# EUROPÄISCHE PATENTANMELDUNG

(11) **EP 3 772 087 A1**
(43) Veröffentlichungstag der Anmeldung: **03.02.2021**
(21) Anmeldenummer: 19189071.4
(22) Anmeldetag: 30.07.2019
(51) Int. Cl.: H01L 21/60, H01L 23/00, H01L 25/07

(54) **MONTAGE EINER ELEKTRONISCHEN BAUGRUPPE**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Schellenberg, Christian, 14480 Potsdam (DE); Strogies, Jörg, 14163 Berlin (DE); Wilke, Klaus, 12527 Berlin (DE)

(57) **Zusammenfassung**

Die Erfindung betrifft ein Verfahren zur Montage einer elektronischen Baugruppe (10), aufweisend zumindest ein Die (40) und ein Substrat (150) mit einer Leitebene (152). Um die elektrische Kontaktierung von Dies bei deren Montage zu vereinfachen wird folgender Schritt vorgeschlagen:
Anordnen von Formteilen (21,...,24), Fügematerialien (30) und dem zumindest einen Die (40), sodass
- der Die (40) mit zumindest einem der Formteile (21,...,24) und einem der Fügematerialien (30) elektrisch kontaktiert wird, und
- sich aus den Formteilen (21,...,24) und/oder dem Die (40) sowie den Fügematerialien (30) mehrere Funktionselemente (61, 62, 63) bilden, die zum Stützen des Substrats (150) und zum elektrischen Kontaktieren der Leitebene (152) ausgebildet werden. Die Erfindung betrifft weiterhin eine elektronische Baugruppe (10).

## Beschreibung

Die Erfindung betrifft ein Verfahren zur Montage einer elektronischen Baugruppe sowie eine elektronische Baugruppe. Ein derartiges Verfahren ist insbesondere bei der Herstellung von leistungselektronischen Baugruppen von Vorteil, z. B. bei der Herstellung von sogenannten "Power Modules" oder Bestandteilen davon.

Die elektronische Baugruppe umfasst dabei ein Substrat mit einer Leitebene und zumindest einen Die. Ein Die ist ein ungehäuster Halbleiter und wird dabei auch als "bare die" oder "Nacktchip" bezeichnet. Das elektrische Kontaktieren des Dies mit elektrischen Anschlüssen anderer Bauteile, weiteren leitenden Strukturen oder mit elektrischen Anschlüssen eines Gehäuses erfolgt im Stand der Technik üblicherweise über Draht-Bonden (im Englischen: "wire bonding"). Alternativ sind Wire-Bond-freie Technologien (z. B. Leadframe, Folien, Ball-Bonding) bekannt.

Es ist Aufgabe der Erfindung ein Verfahren zur Montage von elektronischen Baugruppen anzugeben, welches die elektrische Kontaktierung von Dies bei deren Montage vereinfacht.

Die Aufgabe wird dabei durch ein Verfahren zur Montage einer elektronischen Baugruppe gelöst, wobei die Baugruppe zumindest ein Die und ein Substrat mit einer Leitebene aufweist. Zur Montage werden planare Formteile, Fügematerialien und der zumindest eine Die so angeordnet, dass:
- der Die mit zumindest einem der planaren Formteile und einem der Fügematerialien elektrisch kontaktiert wird,
- sich aus den Formteilen und/oder dem Die sowie den Fügematerialien Funktionselemente bilden, die zum Stützen des Substrats und zum elektrischen Kontaktieren der Leitebene ausgebildet werden. Es ist vorteilhaft, wenn sich mehrere Funktionselemente bilden, da mehrere Funktionselemente das Substrat besser stützen können. Wenn mehrere Dies kontaktiert werden, so werden entsprechend mehr Funktionselemente zum kontaktieren der Dies vorgesehen und die Stützfunktion verbessert sich weiter.

Planare Formteile sind kostengünstig herstellbare planare Teile aus einem elektrisch leitenden Material. Die planaren Formteile werden dabei ohne Biegeprozesse hergestellt, können beispielsweise aus Blechen gestanzt werden und können in variabler Form und Dicke, z. B. als Schüttgut oder aufgerollt als Band einem automatisiert bestückbaren Warenträger zugeführt werden. In der Regel sind die Formteile quader- bzw. plattenförmig. Die Formteile können aber auch scheibenförmig sein oder weitere flache Geometrien aufweisen. Ein Höhenausgleich der Formteile kann im üblichen Fügeprozess (z. B. durch Löten bzw. Sintern) durch Schichten der hierfür notwendigen Materialien erfolgen. Die Formteile sind dabei vorzugsweise Kupferformteile. Die Dimensionierung der Formteile kann vom zu leitenden maximalen Strom abhängen. Die Formteile sind in der Regel zwischen 300 µm und 2mm dick und können variable weitere Dimensionen aufweisen.

Als Fügematerialien können Lot- und/oder Sintermaterialien in Form von druckbaren oder dispensbaren Pasten oder jeweils als Lot- bzw. Sinterformteile zum Einsatz kommen. Das Anordnen der planaren Formteile kann dabei durch Bestückautomaten auf einem Warenträger durchgeführt werden.

Die Funktionselemente bilden während der Montage mechanisch stabile Einheiten und sind zum Stützen des Substrats während des Montageprozesses ausgebildet. Es ist möglich die Funktionselemente einem Fügeprozess zu unterziehen (z. B. thermisches Fügen), bevor das Substrat auf den Funktionselementen positioniert wird. So können die Funktionselemente für die Zwecke der weiteren Montage eine oder mehrere mechanisch in sich stabile Einheiten bilden, was die weitere Handhabbarkeit der Funktionselemente verbessert. Es ist ebenso möglich, die Funktionselemente zusammen mit dem Substrat zu fügen.

Die Funktionselemente bilden eine Stützstruktur, die derart ausgestaltet ist, dass ein Substrat für die weitere Montage der Baugruppe darauf positioniert werden kann. Die Stützstruktur kann dabei so ausgestaltet sein, dass sie das Substrat vollständig trägt. Die Funktionselemente vereinen somit zwei Funktionen, das Stützen und das Kontaktieren, in einem Element. Dadurch bietet die Erfindung das Potential in ausschließlich einem Prozess alle Verbindungsebenen zur Herstellung des Produktes zu realisieren. Weiterhin können durch die variablen planaren Formteile die Funktionselemente elektrisch und thermisch optimiert aufgebaut werden. Dies wird vorzugsweise stapelweise durchgeführt. Die Vorliegende Erfindung vereinfacht die Kontaktierung der Dies und ermöglicht dabei weitere Freiheitsgrade im Aufbau der Baugruppe.

Wenn das Substrat auf den Funktionselementen positioniert und ein Fügeprozess durchlaufen wurde, so gehen die Funktionselemente eine dauerhafte elektrische und mechanische Verbindung mit dem Substrat bzw. dessen Leitebene ein. Die Funktionselemente sind damit mit dem Substrat mechanisch verbunden, die Stützfunktion hat damit ihren Zweck erfüllt und die Funktion des elektrischen Kontaktierens steht nun im Vordergrund.

Eine weitere Ausführungsform umfasst den Schritt des Bereitstellens eines Warenträgers, wobei die Formteile, Dies und/oder Fügematerialien auf dem Warenträger angeordnet werden. Der Warenträger kann dabei eine oder mehrere Aussparungen aufweisen, wobei die Formteile, Dies und/oder Fügematerialien dann so angeordnet werden können, dass sich zumindest ein Teil der Funktionselemente in den Aussparungen bildet. Die Formteile können dabei direkt, d. h. ohne weitere Zwischenelemente, auf dem Warenträger angeordnet werden. Der Warenträger dient dabei in erster Linie dazu, die Baugruppe und ihre Funktionselemente durch den Produktionsprozess zu transportieren. Die Aussparungen können dabei auch so ausgestaltet sein, dass diese eine Stützfunktion für die Funktionselemente, die noch nicht gefügt worden sind, bereitstellen.

Der Warenträger verbleibt nicht an der fertiggestellten Baugruppe. Es ist möglich, dass ein Warenträger bereits mit einer ersten Schicht an ausgewählten Formteilen vorbestückt ist. Ein Warenträger kann dabei tablettähnlich ausgebildet sein oder kann dabei auch als ein Teil eines Förderbandsystems oder anderweitigen, z. B. (teil-) autonomen Fördersystems ausgebildet sein. Die Verwendung eines Warenträgers erhöht vorteilhaft die Handhabbarkeit des vorliegenden Verfahrens. In anderen Worten wird ein intelligentes Warenträgerkonzept zur Verfügung gestellt auf dessen Basis die Fügepartner vollautomatisiert, additiv aufgebaut werden, z. B. durch intelligentes Schichten und Fügen. Es kann vorteilhaft sein, wenn der Warenträger so ausgestaltet ist, dass die Funktionselemente im Wesentlichen eine Ebene bilden. Andere Formen sind dann denkbar und sinnvoll, wenn keine Flachen Substrate zum Einsatz kommen sollen.

In einer weiteren Ausführungsform werden die Funktionselemente voneinander beabstandet gebildet. Die Funktionselemente sind voneinander beabstandet angeordnet, d. h. so angeordnet, dass sie eine Stützfunktion an mehreren Punkten eines darauf positionierten Substrats ausüben können. Dadurch kann eine gleichmäßige Verteilung der Last bzgl. des Substrats erreicht werden. Die Funktionselemente können so angeordnet werden, dass sie das Substrat während des Montageprozesses vollständig tragen können. Die Funktionselemente sind weiterhin so angeordnet, dass das elektrische Kontaktieren der Funktionselemente und des Substrats realisiert werden kann.

In einer weiteren Ausführungsform weist der Warenträger ein oder mehrere Aussparungen mit untereinander verschiedenen Dimensionen auf. Dies kann beispielsweise eine unterschiedlicher Tiefe der Aussparungen beinhalten, z. B. um Höhenunterschiede auszugleichen. Weiterhin kann der Warenträger auf bestimmte Formteile angepasste Aussparungen aufweisen. Die Tiefe der Aussparung korrespondiert mit den Dicken der dort angeordneten Formteile und/oder mit dem notwendigen Höhenausgleich. Die Tiefe der Aussparungen beträgt in der Regel höchstens 2mm, kann aber darüber liegen, wenn besonders Dicke Teile verarbeitet werden sollen.

Eine weitere Ausführungsform umfasst ein Anordnen von ein oder mehreren Hilfselementen. Die Hilfselemente können auf einem Warenträger und/oder unterhalb von Formteilen angeordnet werden. Die Hilfselemente verbleiben dabei nicht dauerhaft in der elektronischen Baugruppe, sondern werden, wenn die Hilfselemente ihren Zweck erfüllt haben - z. B. ein zwischenzeitliches Bereitstellen einer mechanischen Stützfunktion oder einer Schutzfunktion für ein empfindliches Bauteil - wieder entfernt. So können die Hilfselementen auf dem Warenträger verbleiben und können einen größeren Höhenunterschied als der Warenträger ausgleichen und tragen dabei zur Erhöhung der Flexibilität bei. Alternativ oder ergänzend können Hilfselemente erst später im Prozess entfernt werden. Die Hilfselemente können selbst wiederum Aussparungen aufweisen oder bereits mit Bauelementen vorbestückt sein.

Eine weitere Ausführungsform umfasst ein Positionieren des Substrats auf den Funktionselementen, sodass die Leitebene mit den Funktionselementen elektrisch kontaktiert werden. In anderen Worten werden leitende Strukturen der elektrischen Baugruppe, die bisher noch zwischen der Leitebene des Substrats und den die Funktionselementen aufgeteilt waren, durch elektrisches Kontaktieren der Leitebene mit den Funktionselementen vervollständigt. Mit dem Positionieren des Substrats auf den Funktionselementen vervollständigen sich die leitenden Strukturen der Baugruppe und diese können gefügt werden. Das Substrat kann dabei eine strukturierte Leitebene aufweisen und kann bereits weitere elektronische Bauelemente aufweisen. Hier ergibt sich der große Vorteil, dass die Funktionselemente in großer Komplexität und unabhängig vom Substrat aufgebaut werden können und das Substrat erst nachträglich auf Funktionselemente aufgebracht werden kann. Dies ermöglicht hohe Freiheitsgrade in der Gestaltung der elektronischen Baugruppe.

In einer weiteren Ausführungsform ist zumindest eines der zum Kontaktieren des Dies verwendeten Formteile als Anschlussrahmen (im Englischen: Leadframe) ausgebildet. Diese Ausführungsform ist besonders vorteilhaft, da so ein Herstellungsprozess möglich wird, der die Anbindung von Leadframes in den Montageprozess integriert, damit höhere Gestaltungsspielräume ermöglicht und potentiell einen separaten Montage-/Prozessschritt spart. Auch sind Kombinationen mit standardisierten Leadframestrukturen (z. B. in einer Premolded-Variante) denkbar, bei denen produktspezifische Anpassungen durch nachgelagerte Bearbeitungen (z.B. Laserschnitte zum Entfernen von Stützstrukturen bzw. nicht genutzten Verdrahtungslayern) erfolgen.

Die Leadframe-Technologie bietet für die Verdrahtung von Dies aufgrund der Power Cycling Festigkeit und der elektrischen Performance (elektrische und thermische Leitfähigkeit, niedrige Induktivität etc.) hohe Vorteile. Bisher war diese Technologie aufgrund des Initialaufwandes (Werkzeuge für Stanzen, Formen und Molden etc.) für kleine Stückzahlen nicht wirtschaftlich darstellbar. Der Aufwand steigt mit der Komplexität und den Genauigkeitsanforderungen der Leadframes (unterschiedliche Potentiale, variable Leadframe-Querschnitte usw.) .

Es kann vorteilhaft sein, den Anschlussrahmen und die Formteile so anzuordnen, dass sich aus dem Anschlussrahmen, den Formteilen und den Fügematerialien eine Einheit bildet, die im Rahmen der Montage handhabbar ist. Handhabbar heißt hier, dass die Einheit zumindest einen ausreichenden mechanischen Zusammenhalt aufweist, um während der weiteren Prozessschritte nicht wieder in Einzelteile zu zerfallen. Dazu kann z. B. ein Fügeschritt durchgeführt werden, der aus den Funktionselementen eine Einheit bildet. Beispielsweise können teile der Fügematerialien gefügt werden (z. B. durch Sintern oder Löten) .

Eine weitere Ausführungsform umfasst ein Anordnen von elektrisch isolierenden Elementen, sodass sich elektrisch isolierte Stützstellen für das Substrat ausbilden. Dies bietet den Vorteil, dass Formteile unterschiedlicher Potentiale über elektrisch isolierende Formteile an geeigneten Stützstellen isoliert und mechanisch stabilisiert werden können. Auch die Herstellung elektrisch leitender Verbindungen zwischen unterschiedlich geformten Formteilen variabler Dicke ist durch die Verwendung lokaler Verdrahtungsträger möglich. Die Funktionselemente können so entlastet werden und der Gestaltungsspielraum erhöht sich weiter. Die elektrisch isolierenden Elemente verbleiben vorzugsweise in ihrer Funktion als elektrischer Isolator auf der Baugruppe.

Eine weitere Ausführungsform umfasst ein Fügen, sodass die Fügematerialien Verbindungen mit den Formteilen, dem Die und/oder der Leitebene eingehen. Das Fügen kann dabei sowohl die Formteile als auch den Die mit den Fügematerialien verbinden. Hierbei sind Lot und Sinterverfahren denkbar. Besonders vorteilhaft am vorliegenden Verfahren ist dabei, dass die Fügeverfahren nunmehr für alle Funktionselemente und das Substrat gleichzeitig und in einem einzigen Prozessschritt durchgeführt werden können. Falls nötig ist aber ebenso denkbar, wenn z. B. besonders robuste oder mit hoher Stromtragfähigkeit ausgestattete Funktionselemente vonnöten sind, ein mehrteiliges Fügeverfahren durchgeführt wird, mehrere Fügeverfahren kombiniert werden. Zum Beispiel erst ein Sinterverfahren, das hochtemperaturbeständige Sinterverbindungen für den Die erzeugt und anschließend ein Lötverfahren, das das Substrat anbindet.

In einer weiteren Ausführungsform wird zumindest ein weiteres elektrisches Bauelement angeordnet. Dies geschieht vorzugsweise ergänzend zum Anordnen der Formteile, der Dies und der Fügematerialien und kann im gleichen Prozessschritt durchgeführt werden. Dabei können passive und/oder aktive Bauelemente angeordnet werden. Es hat sich als besonders vorteilhaft erwiesen, wenn weitere Bauteile mit den Formteilen verarbeitet werden. Dies kann beispielsweise ein Strom-Mess-Shunt sein, der den Strom in direkter Nähe zum Die misst. So kann neben dem Herstellen von leitenden Verbindungen und Strukturen bereits funktionale Elemente im direkten Umfeld des Dies erstellt werden.

In einer weiteren Ausführungsform wird das Anordnen der planaren Formteile und/oder der Fügematerialien schichtweise durchgeführt. Es hat sich als vorteilhaft erwiesen das Anordnen der Formteile und der Fügematerialien schichtweise durchzuführen, da so z. B. eine Qualitätskontrolle bereits in den einzelnen Schichten des Anordnens möglich ist und wenn sich in einer Schicht Fehler oder Mängel ergeben noch ohne Weiteres Maßnahmen ergriffen werden können.

Die Aufgabe wird weiterhin durch eine elektronische Baugruppe gelöst, die zumindest ein Die, ein Substrat mit einer Leitebene und mehrere voneinander beabstandet angeordnete Funktionselemente aufweist. Der Die ist mit zumindest einem der Formteile und einem der Fügematerialien elektrisch kontaktiert. Die Funktionselemente sind zumindest teilweise aus Formteilen und/oder dem Die sowie Fügematerialien ausgebildet, wobei die Funktionselemente zum Stützen des Substrats, insbesondere während der Produktion und zum elektrischen Kontaktieren der Leitebene ausgebildet sind.

Das PCB weist dabei vorzugsweise aktive Bauelemente auf, die eine sogenannte "Control Unit" bilden und die Steuerlogik zur Ansteuerung der Dies bereitstellen.

Im Folgenden wird die Erfindung anhand der in den Figuren dargestellten Ausführungsbeispiele näher beschrieben und erläutert. Es zeigen:
- FIG 1: einen Warenträger mit einer darauf angeordneten Stützstruktur,
- FIG 2: eine Explosionsansicht einer Stützstruktur,
- FIG 3: eine weitere Ausführungsform eines Warenträgers,
- FIG 4: eine Stützstruktur in Zusammenwirkung mit einem Substrat,
- FIG 5: eine elektronische Baugruppe und
- FIG 6: einen möglichen weiteren Produktionsschritt.

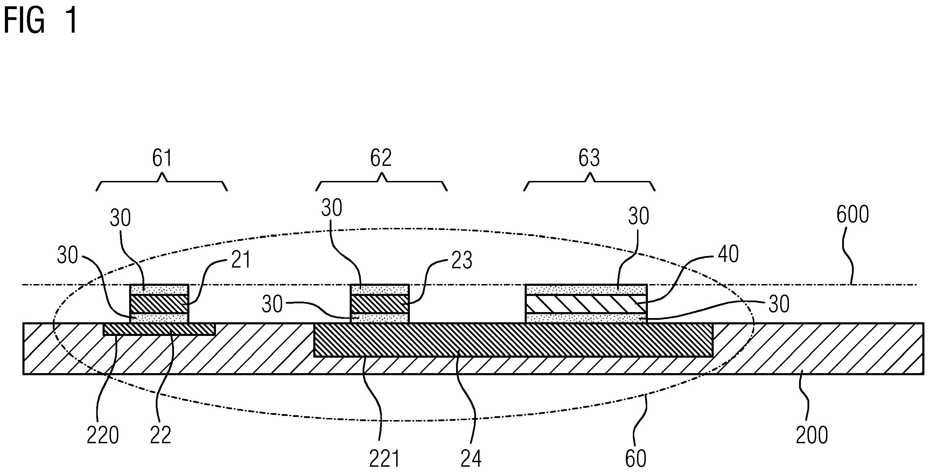

FIG 1 zeigt einen Warenträger 200, in dem erfindungsgemäße Funktionselemente 61, 62, 63 angeordnet worden sind. Die Funktionselemente 61, 62, 63 bilden dabei eine Stützstruktur 60. Die Funktionselemente 61, 62, 63 bilden weiterhin eine Kontaktfläche 600 der Stützstruktur 60, die in diesem Fall als eine Ebene ausgebildet ist und um in den nächsten Prozessschritten ein Substrat 150, das hier nicht gezeigt ist, zu stützen. Der Warenträger 200 weist zwei Aussparungen 220 und 221 auf, wobei in der Aussparung 220 das Stützelement 61 angeordnet ist und in der Aussparung 221 die Funktionselemente 62 und 63 angeordnet sind, die auf einer gemeinsamen Basis fußen. Das Stützelement 61 weist dabei Formteile 21, 22 und Fügematerialien 30 auf. Das Stützelement 62 weist dabei Formteile 23 und einen Teil des Formteils 24 sowie Fügematerialien 30 auf. Ein Die 40, z.B. ein Halbleiterschalter wie ein IGBT-Bare-Die, ist mit Fügematerialien 30 auf dem Formteil 24 angeordnet, sodass der Die 40 ein Stützelement 63 bildet. Gleichzeitig ist die Die-Oberseite und die Die-Unterseite durch die gemeinsame Basis, das Formteil 24, auf eine gemeinsame Ebene (die Ebene der Kontaktfläche 600) gebracht worden. So kann eine Kontaktierung von Dies stark vereinfacht werden.

Es ist zu beachten, dass die Formteile 21,...,24 direkt auf dem Warenträger 200 angeordnet werden und nicht auf einem Substrat aufgebracht werden. Diese Art der Anordnung ermöglicht eine höhere Flexibilität und erheblich mehr Freiheitsgrade im Aufbau der Kontaktstrukturen, die mit einem Substrat verbunden werden sollen.

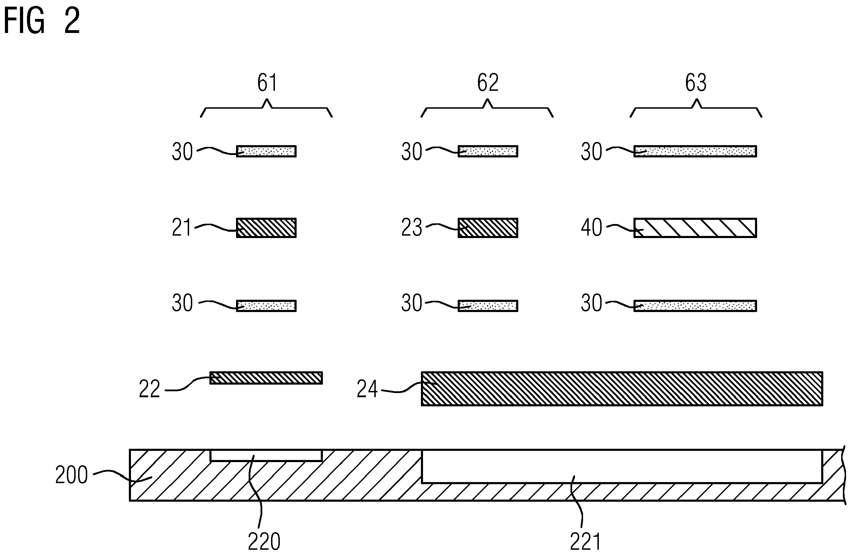

FIG 2 zeigt eine Explosionsansicht der Funktionselemente 61, 62, 63 bzw. der Stützstruktur 60, wie sie aus FIG 1 bekannt ist. Das Stützelement 61 wird dabei aus einem Kupferformteil 22, das in die Aussparung 220 eingelegt wird, einem Fügematerial 30, einem weiteren Kupferformteil 21 sowie einem abschließenden weiteren Fügematerial 30 stapelweise angeordnet. Das Formteil 21 ist dabei ein sehr flaches Kupferformteil, im Vergleich dazu wird in eine Aussparung 221 ein deutlich dickeres und breiteres Kupferformteil 24 eingelegt. Die unterschiedlichen Dicken werden vorliegend durch unterschiedliche Tiefen der Aussparungen 220,221 ausgeglichen. Das Kupferformteil 24 dient als Basis für zwei weitere Funktionselemente 62, 63, die folglich über das Kupferformteil 24 elektrisch verbunden sind. Die Dimensionen der Formteile können dabei anhand von thermischen und Leistungskriterien gewählt werden. Auch die Fügematerialien 30 können auf ihre Formteile angepasst sein. So ist es denkbar, dass für den dabei spezielle Bügelmaterialien 30 zur Anwendung kommen, wohingegen für die Kupferformteile 21,...,24 weitere Fügematerialien 30 zum Einsatz kommen.

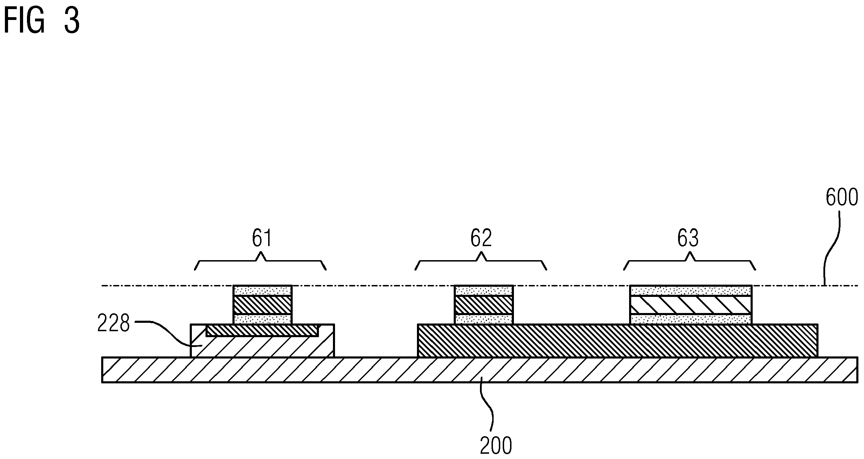

FIG 3 zeigt eine weitere Ausführungsform eines Warenträger 200, wobei dieser keine Aussparungen aufweist, sondern mittels eines Hilfselements 228 einen Höhenausgleich zwischen den Funktionselementen 61, 62 und 63, wie sie aus FIG 1 und 2 bekannt sind, vornimmt. Das Hilfselement 228 kann bereits erste Formteile bzw. vorgefertigte Funktionselemente aufweisen und direkt zur Verfügung gestellt werden, sei es in anderen Worten das Hilfselement 228 wird bereits mit Formteilen angeliefert und dann mit weiteren Formteilen 21,...,24 zusammen auf dem Warenträger 200, z. B. mit einem Bestückautomaten, angeordnet. Es ist aber ebenso denkbar, dass das Hilfselement 228 als Teil des Warenträger 200 ausgebildet ist. Die Kontaktfläche 600 bleibt wie in den vorigen FIG 1 und 2 gezeigt Eben.

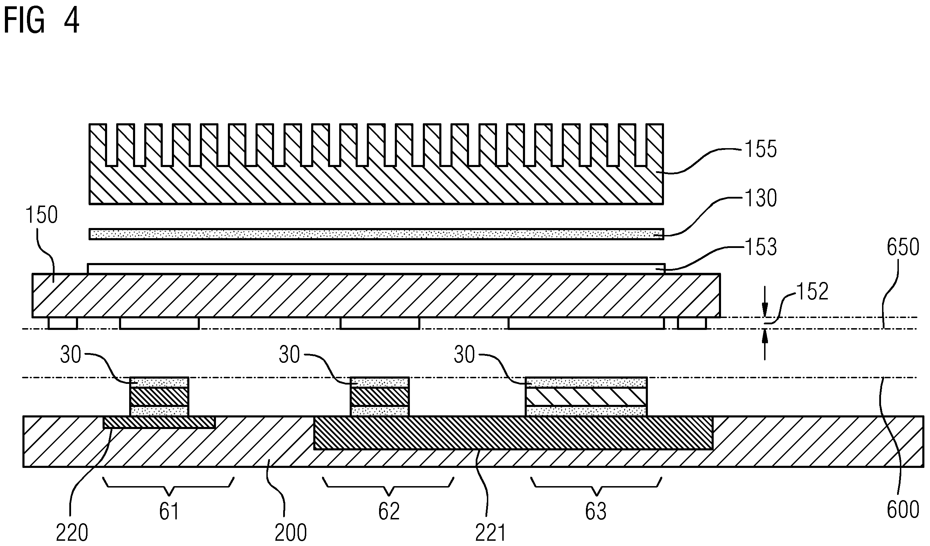

FIG 4 zeigt, wie die Stützstruktur 60 mit einem Substrat 150 zusammenwirkt. Das Substrat 150 weist eine in diesem Fall eine bereits strukturierte Leitebene 152 auf. Auf der oberen Seite des Substrats 150 ist eine Kaschierung 153 vorgesehen, die zur Anbindung eines Kühlkörpers 155 mit einem Kühlkörper-Fügematerial 130 an das Substrat 150 dient. Das Substrat 150 bzw. die Leitebene 152 weist eine Kontaktfläche 650 der Leitebene 152 auf. Die Kontaktfläche 650 der Leitebene 152 ist dabei so ausgestaltet, dass sie auf die Kontaktebene 600 der Stützstruktur 60 aufgelegt werden kann. In anderen Worten werden die Funktionselemente 61, 62, 63 im Zusammenhang mit der Leitebene 152 so ausgestaltet bzw. ausgelegt, dass diese ihre Stützfunktion und die elektrische Kontaktierung des Dies 40 realisieren können. An dieser Stelle ist zu erwähnen, dass die Stützfunktion für den Produktionsprozess gilt. Wenn ein Fügeprozess, z.B. Löten und/oder Sintern, durchlaufen wurde, so ist diese Stützfunktion zum Großteil nicht mehr notwendig und die Funktionselemente 61,62,63 dienen hauptsächlich ihrer zweiten Funktion des elektrischen Kontaktierens, insbesondere des Dies 40.

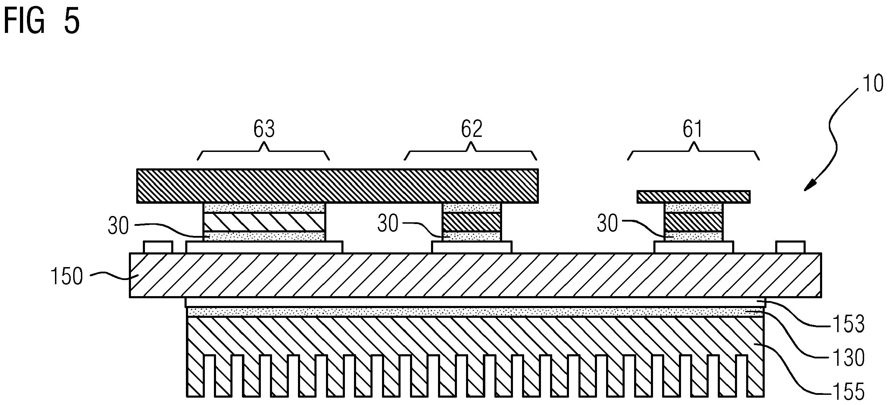

FIG 5 zeigt die fertiggestellte elektronische Baugruppe 10, wie sie in FIG 4 montiert wurde. Die Baugruppe 10 wurde dabei vom Warenträger 200 entfernt und zur weiteren Verarbeitung umgedreht. Die in dieser Figur gezeigte Ausrichtung entspricht dabei der Ausrichtung, in der elektronische Baugruppen üblicherweise bestückt werden. Das erfindungsgemäße Verfahren ermöglicht hier mehr Freiheitsgrade, indem die Funktionselemente 61, 62, 63 unabhängig vom Substrat 150 angeordnet werden und daher optimal z. B. bzgl. Temperatur und/oder elektrischer Leistung aufgebaut werden können. Beispielhaft kann die in FIG 5 gezeigte Baugruppe 10 mit den folgenden Schritten und in der folgenden Reihenfolge aufgebaut werden:
- Bereitstellen eines Warenträgers 200, wobei die Formteile 21,...,24, Dies 40 und/oder Fügematerialien 30 so auf dem Warenträger 200 angeordnet werden, dass
- der Die 40 mit zumindest einem der planaren Formteile 21,...,24 und einem der Fügematerialien 30 elektrisch kontaktiert wird,
- sich Funktionselemente 61, 62, 63 aus den planaren Formteilen 21,...,24 und/oder dem Die 40 sowie den Fügematerialien 30 bilden, die zum Stützen des Substrats 150 und zum elektrischen Kontaktieren der Leitebene 152 ausgebildet werden,
- Fügen, sodass die Fügematerialien 30 Verbindungen mit den Formteilen 21,...,24, dem Die 40 und/oder der Leitebene 152 eingehen und schließlich
- Wenden der Baugruppe 10 für die weitere Verarbeitung.

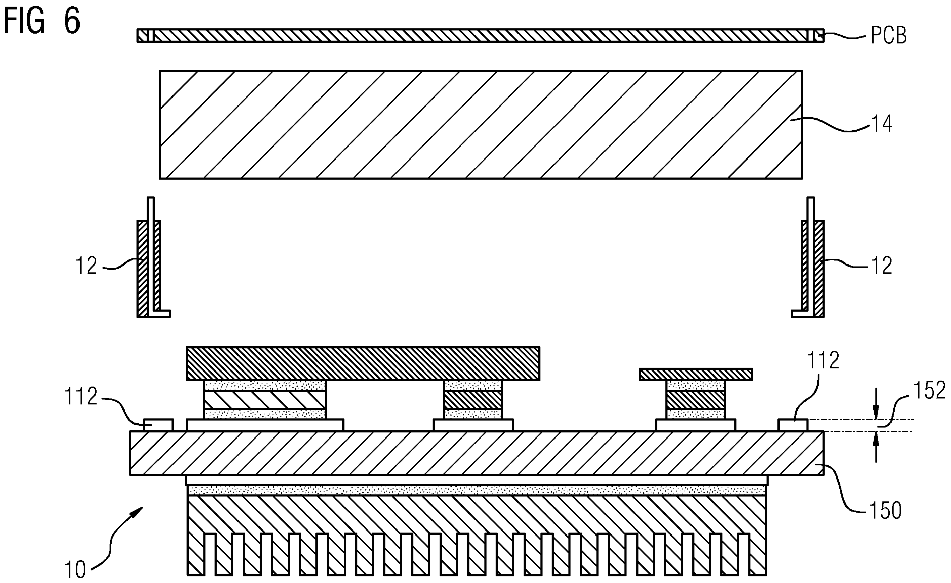

FIG 6 zeigt einen möglichen weiteren Produktionsschritt der elektrischen Baugruppe 10 aus FIG 5. Die strukturierte Leitebene 152 des Substrats 150 weist Kontakte 112 für einen Rahmen 12 mit Pins auf. Wenn der Rahmen 12 mit Pins mit der elektrischen Baugruppe 10 verbunden ist kann ein Vergussmaterial 14 eingegossen werden, um einen Schutz der elektronischen Baugruppe 10 und der darauf angeordneten Bauelemente zu ermöglichen. Eine Steuerelektronik PCB, in diesem Fall als Printed Circuit Board ausgeführt, kann anschließend kontaktiert werden und ist beispielsweise zur Ansteuerung einer Leistungselektronik ausgebildet, die mit dem erfindungsgemäßen Verfahren hergestellt wurde.

Zusammenfassend betrifft die Erfindung ein Verfahren zur Montage einer elektronischen Baugruppe 10, aufweisend zumindest ein Die 40 und ein Substrat 150 mit einer Leitebene 152. Um die elektrische Kontaktierung von Dies bei deren Montage zu vereinfachen wird folgender Schritt vorgeschlagen:
Anordnen von planaren Formteilen 21,...,24, Fügematerialien 30 und dem zumindest einen Die 40, sodass
- der Die 40 mit zumindest einem der planaren Formteile 21,...,24 und einem der Fügematerialien 30 elektrisch kontaktiert wird, und
- sich Funktionselemente 61, 62, 63 aus den planaren Formteilen 21,...,24 und/oder dem Die 40 sowie den Fügematerialien 30 bilden, die zum Stützen des Substrats 150 und zum elektrischen Kontaktieren der Leitebene 152 ausgebildet werden. Die Erfindung betrifft weiterhin eine elektronische Baugruppe 10.

### Bezugszeichenliste

- 10: elektronische Baugruppe
- 12: Rahmen mit Pins
- 14: Vergussmaterial
- PCB: Steuerelektronik
- 21, 22, 23, 24: planare Formteile
- 26: isolierende Formteile
- 30: Fügematerialien
- 40: Die
- 60: Stützstruktur
- 61, 62, 63: Funktionselemente
- 150: Substrat
- 152: Leitebene
- 200: Warenträger
- 220, 221: Aussparungen
- 228: Hilfselement

- 600: Kontaktfläche
- 650: Kontaktfläche der Leitebene

## Patentansprüche

1. Verfahren zur Montage einer elektronischen Baugruppe (10) aufweisend zumindest ein Die (40) und ein Substrat (150) mit einer Leitebene (152), umfassend den Schritt:
Anordnen von planaren Formteilen (21,...,24), Fügematerialien (30) und dem zumindest einen Die (40), sodass
- der Die (40) mit zumindest einem der planaren Formteile (21,...,24) und einem der Fügematerialien (30) elektrisch kontaktiert wird, und
- sich Funktionselemente (61, 62, 63) aus den planaren Formteilen (21,...,24) und/oder dem Die (40) sowie den Fügematerialien (30) bilden, die zum Stützen des Substrats (150) und zum elektrischen Kontaktieren der Leitebene (152) ausgebildet werden.

2. Verfahren nach Anspruch 1, umfassend den Schritt: Bereitstellen eines Warenträgers (200), wobei die Formteile (21,...,24), Dies (40) und/oder Fügematerialien (30) auf dem Warenträger (200) angeordnet werden.

3. Verfahren nach einem der vorhergehenden Ansprüche, wobei die Funktionselemente (61, 62, 63) voneinander beabstandet gebildet werden.

4. Verfahren nach einem der vorhergehenden Ansprüche, wobei der Warenträger (200) ein oder mehrere Aussparungen (220, 221) mit untereinander verschiedenen Dimensionen aufweist.

5. Verfahren nach einem der vorhergehenden Ansprüche, umfassend den Schritt: Bereitstellen von ein oder mehreren Hilfselementen (228), insbesondere auf einem Warenträger (200) .

6. Verfahren nach einem der vorhergehenden Ansprüche, umfassend den Schritt: Positionieren des Substrats (150) auf den Funktionselementen (61, 62, 63), sodass die Leitebene (152) mit den Funktionselementen (61, 62, 63) elektrisch kontaktiert wird.

7. Verfahren nach einem der vorhergehenden Ansprüche, wobei zumindest eines der zum Kontaktieren des Dies (40) verwendeten Formteile (21,...,24) als ein Anschlussrahmen ausgebildet ist.

8. Verfahren nach einem der vorhergehenden Ansprüche, umfassend den Schritt: Anordnen von elektrisch isolierenden Elementen, sodass sich elektrisch isolierte Stützstellen für das Substrat (150) ausbilden.

9. Verfahren nach einem der vorhergehenden Ansprüche, ferner umfassend den Schritt: Fügen, sodass die Fügematerialien (30) Verbindungen mit den Formteilen (21,...,24), dem Die (40) und/oder der Leitebene (152) eingehen.

10. Verfahren nach einem der vorhergehenden Ansprüche, wobei zumindest ein elektrisches Bauelement angeordnet wird.

11. Verfahren nach einem der vorhergehenden Ansprüche, wobei das Anordnen der planaren Formteile (21,...,24) und/oder der Fügematerialien (24) schichtweise durchgeführt wird.

12. Elektronische Baugruppe (10) aufweisend zumindest ein Die (40), ein Substrat (150) mit einer Leitebene (152) und Funktionselemente (61, 62, 63),
wobei der Die (40) mit zumindest einem der Formteile (21,...,24) und einem der Fügematerialien (30) elektrisch kontaktiert ist, wobei die Funktionselemente (61, 62, 63) aus Formteilen (21,...,24) und/oder dem Die (40) sowie Fügematerialien (30)ausgebildet sind, und zum Stützen des Substrats (150) und zum elektrischen Kontaktieren der Leitebene (152) ausgebildet sind.
